(19) Europäisches Patentamt
European Patent Office
Office européen des brevets

(11) **EP 3 312 624 A1**

(12) **EUROPÄISCHE PATENTANMELDUNG**

(43) Veröffentlichungstag:
**25.04.2018   Patentblatt 2018/17**

(21) Anmeldenummer: **16194366.7**

(22) Anmeldetag: **18.10.2016**

(51) Int Cl.:
**G01R 31/28** (2006.01)   G01M 7/00 (2006.01)
**G01N 29/28** (2006.01)   G01R 31/304 (2006.01)
**H04R 17/00** (2006.01)   G01R 31/312 (2006.01)

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(71) Anmelder: **Dyconex AG**
**8303 Bassersdorf (CH)**

(72) Erfinder: **Bihler, Eckardt**
**8406 Wintherthur (CH)**

(74) Vertreter: **Galander, Marcus**
**Biotronik SE & Co. KG**
**Corporate Intellectual Properties**
**Woermannkehre 1**
**12359 Berlin (DE)**

(54) **ANORDNUNG UND VERFAHREN ZUR VIBRATIONSPRÜFUNG VON LEITERPLATTEN**

(57)    Die Erfindung betrifft eine Anordnung für die Prüfung von Leiterplatten-Prüflingen (1) mit mindestens einem elektrischen Netz. Um intermittierende Fehler und Schwachstellen zu erkennen, weist die Anordnung
- mindestens eine Schallerzeugungseinheit (11) mit einem Schallgeber (15),
- mindestens ein Befestigungselement (19, 103, 104) zur Befestigung eines Prüflings (1) über eine Koppelschicht (17) an dem Schallgeber (15) sowie
- eine Messeinheit (12) mit einer Strom- oder Spannungsquelle (13) auf, wobei die Strom- oder Spannungsquelle (13) elektrisch mit einem Eingang (24) eines elektrischen Netzes des Prüflings (1) verbindbar ist, wobei die Messeinheit (12) mit einem Ausgang (25) des jeweiligen elektrischen Netzes des Prüflings (1) elektrisch verbindbar und zur Erfassung eines zeitabhängigen Strom- und/oder Spannungssignals an dem Ausgang (25) des jeweiligen elektrischen Netzes des Prüflings (1) während und/oder nach Einkoppeln einer von dem Schallgeber (15) erzeugten, vorgegebenen Schallwelle über die Koppelschicht (17) in den Prüfling (1) eingerichtet ist. Die Erfindung betrifft ferner ein entsprechendes Verfahren für die Prüfung von Leiterplatten-Prüflingen.

**Fig. 1**

EP 3 312 624 A1

**Beschreibung**

Die Erfindung betrifft eine Anordnung für die Prüfung von Leiterplatten-Prüflingen sowie ein entsprechendes Verfahren.

Die Erkennung von Fehlern, Schwachstellen und Inhomogenitäten in Leiterplatten ist wichtig, um die Qualität und die Lebensdauer einer derartigen Leiterplatte oder Baugruppe beurteilen zu können.

Als Leiterplatte wird im Rahmen der vorliegenden Erfindung ein elektrisch isolierender Träger für elektronische Bauteile verstanden, der gegebenenfalls aus mehreren elektrisch leitenden oder elektrisch isolierenden Schichten besteht und/oder Durchkontaktierungen aufweist. Die Leiterplatte besitzt zudem auf oder in dem Träger angeordnete elektrisch leitende Verbindungen (auch als Leiterbahnen-Netz bezeichnet) und Anschlüsse. Die Leiterplatte kann gegebenenfalls montierte elektrische oder elektronische Bauelemente aufweisen.

Mittels herkömmlicher elektrischer Prüftechnik für derartige Leiterplatten lassen sich intermittierende Schwachstellen und Inhomogenitäten nicht zuverlässig ermitteln. Insbesondere Schwachstellen, die zum Zeitpunkt der Prüfung unauffällig sind, jedoch kurze Zeit später beim bestimmungsgemäßen Einsatz der Leiterplatte zu Fehlfunktion oder Ausfall der Leiterplatte führen, können ohne Zerstörung oder Belastung der Leiterplatten nur mit hohem Aufwand erkannt werden. Derartige herkömmliche Prüfverfahren sind beispielsweise bildgebende Verfahren mittels Röntgenstrahlen oder Ultraschall, mit denen die Leiterplatte gewissermaßen durchleuchtet wird. Die Beurteilung der Leiterplatte erfolgt hierbei visuell und ist daher zeitraubend, nicht quantifizierbar und fehleranfällig.

Die Aufgabe der vorliegenden Erfindung besteht somit darin, eine Anordnung für die Prüfung von Leiterplatten-Prüflingen zu schaffen, welche mit geringem Aufwand eine Erkennung derartiger spät wirkender Schwachstellen und Inhomogenitäten ermöglicht. Hierbei sollen an den Leiterplatten zusätzliche Strukturen lediglich für die Zwecke der Messtechnik vermieden werden. Die Aufgabe besteht ferner darin, ein entsprechendes Verfahren zur Prüfung von Leiterplatten anzugeben.

Die obige Aufgabe wird gelöst durch eine Anordnung für die Prüfung von Leiterplatten-Prüflingen aufweisend

- mindestens eine Schallerzeugungseinheit mit einem Schallgeber,
- mindestens ein Befestigungselement zur Befestigung eines Prüflings über eine Koppelschicht an dem Schallgeber sowie
- eine Messeinheit mit einer Strom- oder Spannungsquelle, wobei die Strom- oder Spannungsquelle elektrisch mit einem Eingang eines (vorgegebenen, zu untersuchenden) elektrischen Netzes des Prüflings verbindbar ist, wobei die Messeinheit mit einem Ausgang des jeweiligen elektrischen Netzes des Prüflings elektrisch verbindbar und zur Erfassung eines zeitabhängigen Strom- und/oder Spannungssignals an dem Ausgang des jeweiligen elektrischen Netzes des Prüflings während und/oder nach Einkoppeln einer von dem Schallgeber erzeugten, vorgegebenen Schallwelle über die Koppelschicht in den Prüfling eingerichtet ist.

Durch die erfindungsgemäße Anordnung wird die Leiterplatte mit ihren sämtlichen Strukturen durch die von dem Schallgeber erzeugte, vorgegebene Schallwelle (d. h. durch die eingeprägten lokalen Druck- und Dichteschwankungen in der Leiterplatte) mechanisch belastet. Die hierdurch entstehenden lokalen Druck- bzw. Zugspannungen breiten sich im gesamten Volumen der Leiterplatte aus und gelangen auch zu Übergängen im Schichtaufbau. An Stellen im Schichtaufbau, die grenzwertige Haftungen, Lufteinschlüsse und vergleichbare Inhomogenitäten im Material aufweisen, werden durch die punktuellen mechanischen Spannungen kurzzeitige Unterbrechungen oder Umladungen in dem jeweiligen elektrischen Netz verursacht, welches durch eine an dem Eingang des jeweiligen elektrischen Netzes des Prüflings anliegende elektrische Spannung oder Strom in der Leiterplatte vorhanden ist. Diese elektrischen bzw. magnetischen Änderungen können durch eine Erfassung eines Strom- und/oder Spannungssignals an dem Ausgang des jeweiligen elektrischen Netzes des Prüflings zeitabhängig während und/oder nach dem Einkoppeln der Schallwelle detektiert und zur Qualitätskontrolle ausgewertet werden. Hierbei erfolgt die zeitabhängige Erfassung des Strom- und/oder Spannungssignals am Ausgang des jeweiligen elektrischen Netzes des Prüflings vorzugweise über eine große Bandbreite, besonders bevorzugt in einem Frequenzbereich zwischen 1 kHz bis 1 GHz. Bevorzugt wird als Schallwelle eine Stoßwelle mit großer Amplitude (bevorzugt größer als 100 Pa, besonders bevorzugt größer als 500 Pa) und kurzer Anstiegszeit (bevorzugt im Bereich 100 ps bis 500 ns) verwendet.

Entsprechend wird auch die obige Aufgabe durch das erfindungsgemäße Verfahren zur Prüfung von Leiterplatten-Prüflingen mit mindestens einem elektrischen Netz und mit den folgenden Schritten gelöst:

- Befestigung eines Prüflings über eine Koppelschicht an einem Schallgeber einer Schallerzeugungseinheit, wobei die Koppelschicht zwischen Prüfling und Schallgeber angeordnet ist, wobei Lufteinschlüsse in oder an der Koppelschicht vorzugsweise durch Aufdrücken des Prüflings auf den Schallgeber entfernt werden,
- elektrisches Verbinden einer Strom- oder Spannungsquelle einer Messeinheit mit einem Eingang eines (vorgegebenen, zu untersuchenden) elektrischen Netzes des Prüflings,

- Erfassen eines zeitabhängigen Strom- und/oder Spannungssignals an einem Ausgang des jeweiligen elektrischen Netzes des Prüflings während und/oder nach dem Einkoppeln einer von dem Schallgeber erzeugten, vorgegebenen Schallwelle über die Koppelschicht in den Prüfling.

Wie oben bereits erläutert wurde, erzeugt die mechanische Belastung durch die eingebrachte Schallwelle (vorzugsweise als Stoßwelle ausgebildet) Unterbrechungen oder Umladungen in dem jeweiligen elektrischen Netz an Stellen der Leiterplatte mit Inhomogenitäten oder Schwachstellen. Diese sind durch Bewertung des am Ausgang des Prüflings anliegenden zeitabhängigen elektrischen Signals erfassbar. Hierdurch kann auf kostengünstige Weise mit geringem Aufwand eine Prüfung von Leiterplatten zur Ermittlung von Inhomogenitäten und Schwachstellen durchgeführt werden. Die zu erwartende Lebensdauer der Leiterplatte wird durch das Prüfverfahren nicht beeinträchtigt. Das erfindungsgemäße Verfahren bzw. die erfindungsgemäße Vorrichtung ermöglicht es jedoch, die Leiterplatten zu erkennen und auszusortieren, die bekannte Tests ohne Beanstandungen durchlaufen haben, aber dennoch kritische Schwachstellen aufweisen. Hierdurch kann die Wahrscheinlichkeit von Frühausfällen im Feld reduziert werden.

Der Schallgeber ist erfindungsgemäß beispielsweise als planparallele Platte aus Quarz oder aus einer piezoelektrischen Keramik gestaltet, welche mittels der Schallerzeugungseinheit, die mit dem Schallgeber elektrisch verbunden ist, zur Erzeugung der vorgegebenen Schallwelle zur Prüfung der Leiterplatte angeregt wird. Der Koppelfilm besteht vorzugsweise aus Wasser mit Detergenzien (Tenside, z. B. Seifenlösung) oder Gel (z. B. Ultraschallgel) oder Öl (z. B. Nähmaschinenöl) und ermöglicht eine gute mechanische Ankopplung des Schallgebers an die zu prüfende Leiterplatte. Hierbei ist die Leiterplatte so an der Schallgeber-Platte befestigt, dass die jeweils größten Seitenflächen von Leiterplatte und Schallgeber-Platte parallel verlaufen.

Im Rahmen der vorliegenden Erfindung wird davon ausgegangen, dass die elektrischen Komponenten des Leiterplatten-Prüflings mindestens ein elektrisches Netz, meist eine Vielzahl von elektrischen Netzen, sowie Metallflächen ausbilden, wobei die Metallflächen untereinander verbunden sind und, elektrisch gesehen, Masseflächen entsprechen. Ein elektrisches Netz stellt elektrische Verbindungen zwischen verschiedenen auf der Oberfläche der Leiterplatte angeordneten kleinen Metallflächen dar, die als Anschlusspunkte für auf der Leiterplatte montierte Komponenten dienen. Ein Netz zeichnet sich insbesondere dadurch aus, dass alle zu einem einzigen Netz gehörenden Anschlusspunkte elektrisch durch in der Leiterplatte verlaufenden Leiterzüge und Durchkontaktierungen miteinander verbunden sind. Für ein erstes elektrisches Netz sind mindestens zwei Anschlusspunkte und ein diese verbindender Leiterzug notwendig. Ein weiteres Netz umfasst ebenfalls mindestens zwei Anschlusspunkte und einen diese verbindender Leiterzug, wobei keine elektrisch leitende Verbindung zu den mindestens zwei Anschlusspunkten und dem Leiterzug des ersten Netzes besteht. Zur Prüfung eines Leiterplatten-Prüflings wird nun jedes elektrisches Netz beispielsweise mit Nadeln geeigneter Adapter der erfindungsgemäßen Anordnung kontaktiert und erfindungsgemäß beschaltet. Im Folgenden wird dazu zwischen dem Eingang und dem Ausgang eines elektrischen Netzes unterschieden, womit jeweils eine mittels Nadeln kontaktierte, an der Oberfläche liegende Metallfläche mit elektrischer Verbindung zum betreffenden elektrischen Netz gemeint ist.

Vorzugsweise wird die Qualität des Prüflings basierend auf dem durch die Messeinheit erfassten zeitabhängigen Strom- und/oder Spannungssignal durch die Messeinheit beurteilt. Ein zu beurteilendes elektrisches Netz des Prüflings wird mittels eines Nadeladapters an dem Eingang und dem Ausgang des Netzes auf dem Prüfling kontaktiert und mittels der Strom- oder Spannungsquelle auf eine zeitlich konstante Spannung von vorzugsweise mindestens 10 V, besonders bevorzugt mindestens 100 V, gegenüber der nächsten Masseebene gesetzt. Das jeweilige elektrische Netz hat eine charakteristische Kapazität gegenüber der Masseebene. Diese Kapazität wird durch die Länge der Leiterzüge und die Abstände zur Masseebene, also die dreidimensionale Struktur des jeweiligen elektrischen Netzes, bestimmt. Wird nun eine oben beschriebene Schallwelle (Stoßwelle) in den Prüfling eingekoppelt, führt dies dazu, dass sich durch die Schallwelle die Abstände zwischen den Leitern und der Masseebene des jeweiligen elektrischen Netzes verändern. Die Kapazität des jeweiligen elektrischen Netzes gegen Masse ändert sich somit synchron zur Schallwelle. Es wird folglich ein mit der Schallwelle synchroner, hochfrequenter Umladestrom in dem jeweiligen elektrischen Netz erzeugt. Dieser hochfrequente Umladestrom wird nun beispielsweise über einen Hochpass aus dem mit konstanter Spannung aufgeladenen Netz abgetrennt und verstärkt. Der hochfrequente Verlauf des Umladestromes wird digitalisiert und beispielsweise über den Zeitraum der eingekoppelten Schallwelle integriert. Dieses Integral des gemessenen Signalstromes entspricht einer elektrischen Ladung, die charakteristisch für das gemessene Netz ist, und wird zur Bewertung der Qualität des Prüflings herangezogen. Hierfür wird das gemessene Integral des vorgegebenen elektrischen Netzes nun mit den auf gleicher Weise an demselben Netz für andere Prüflinge aus der gleichen Produktionscharge gemessenen Integralen oder mit einem gemessenen Integral für dasselbe Netz eines den Qualitätsanforderungen entsprechenden Muster-Prüflings verglichen. Statistisch signifikante Abweichungen des gemessenen Integrals eines Prüflings zu den gemessenen Integralen der restlichen Gruppe von Prüflingen oder zu dem gemessenen Integral des Muster-Prüflings weisen auf Inhomogenitäten bzw. latente Fehler im betreffenden Netz des Prüflings hin.

Es ist weiter von Vorteil, das am Ausgang des Prüflings anliegende zeitabhängige Spannungssignal durch die Messeinheit kapazitiv zu erfassen, da hierdurch eine berührungslose Prüfung der Leiterplatte möglich ist. Dieses Ausführungsbeispiel ist dann von Vorteil, wenn der Leiterplatten-Prüfling lediglich ein einziges elektrisches Netz enthält.

In einem bevorzugten Ausführungsbeispiel wird mittels der Schallerzeugungseinheit die Schallwelle durch den Schallgeber in eine Richtung senkrecht zu der größten Flächenausdehnung des Prüflings (Leiterplatte) ausgesendet und über die Koppelschicht in den Prüfling eingekoppelt. Dies bedeutet, dass die Schallwelle sich senkrecht zu den Schichtebenen der Leiterplatte ausbreitet.

Erfindungsgemäß ist weiter vorgesehen, dass das mindestens eine Befestigungselement als schallweicher oder schallharter Niederhalter ausgebildet ist, je nachdem, ob mehrfache Reflexionen der Stoßwelle in den Prüfling ermöglicht oder unterbunden werden sollen. Besonders bevorzugt weist das Befestigungselement mindestens eine durchgehende Öffnung auf, welche eine elektrische Verbindung des Eingangs oder des Ausgangs des elektrischen Netzes mit der Messeinheit ermöglicht. Ein schallweicher Niederhalter ist zu bevorzugen, da durch diesen eine Reflexion der Schallwelle (Stoßwelle) an der Grenzfläche der Leiterplatte wieder zurück in den Prüfling vermieden werden kann. Reflexionen können zu Fehlinterpretationen führen, da nach Reflexion der Schallwelle am Niederhalter ein weiteres elektrisches Signal im Messkreis induziert wird. Ein bevorzugtes Ausführungsbeispiel für einen schallweichen Niederhalter stellt eine beispielsweise 1 mm bis 3 mm dicke Gummimatte dar, die mittels einer Platte aus Metall auf die Leiterplatte gedrückt wird, so dass ein guter Kontakt zwischen Leiterplatte und Gummimatte entsteht. Die Schallwelle wird bei diesem Ausführungsbeispiel mit geringfügiger Reflexion aus der Leiterplatte austreten und in der Gummiwelle abgedämpft. Die Gummimatte und die dazu passende Metallplatte bilden demnach den Niederhalter. Der Niederhalter weist an den Stellen, wo Messsignale mit einem Nadeladapter vom Prüfling aufgenommen werden sollen, eine durchgehende Öffnung auf, um einen elektrischen Kontakt zwischen der Nadel und dem Prüfling herstellen zu können.

Eine besonders einfache Auswertung des am Ausgang des Prüflings erfassten Messsignals kann dadurch erreicht werden, dass die Messeinheit das erfasste Strom- und/oder Spannungssignal, das zeitabhängig ermittelt wurde, mit der Schallwelle vergleicht oder mit dieser faltet (Faltung im mathematischen Sinne). Insbesondere durch die Faltung kann ein skalarer Messwert bestimmt werden, der statistisch mit vorhandenen Messungen an gleichen Prüflingen (gleiches Netz und gleiche Designparameter der Leiterplatte) verglichen werden kann. Hierdurch kann dann festgestellt werden, ob es sich um eine den Qualitätsanforderungen entsprechende Leiterplatte oder um eine schadhafte Leiterplatte handelt.

Es ist weiter von Vorteil, wenn die Strom- oder Spannungsquelle als Gleichstrom- bzw. Gleichspannungsquelle ausgebildet ist. Je nach Prüfling kann beispielsweise bei am Eingang des jeweiligen elektrischen Netzes des Prüflings anliegendem konstantem Strom der Strom am Ausgang des elektrischen Netzes erfasst und der konstante DC-Anteil mittels eines Hochpasses abgetrennt werden. Bei dieser Messmethode können durch die Schallwelle induzierte hochfrequente Widerstandsänderungen des betrachteten elektrischen Netzes besser gemessen, d. h. verstärkt, werden. Alternativ kann der Eingang des jeweiligen elektrischen Netzes des Prüflings mit einer Gleichspannungsquelle verbunden werden, sodass im Netz des Prüflings eine konstante Spannung gegen Masse oder Vcc (positive Spannungsversorgung) anliegt. Als Messgröße am Ausgang des jeweiligen elektrischen Netzes des Prüflings kann beispielsweise der Strom erfasst werden. Gegenüber dem zuvor beschriebenen Fall wird bei diesem Ausführungsbeispiel der durch die Schallwelle induzierte Aufladestrom der elektrischen Kapazität des betrachteten elektrischen Netzes gegen Masse oder Vcc gemessen.

Ein alternatives Verfahren kann dadurch realisiert werden, dass die Strom- oder Spannungsquelle zur Erzeugung eines Strom- oder Spannungspulses am Eingang des jeweiligen elektrischen Netzes des Prüflings in einem vorgegebenen zeitlichen Abstand zu dem Beginn der vorgegebenen Schallwelle eingerichtet ist. Hierbei ist in der erfindungsgemäßen Anordnung die Schallerzeugungseinheit mit der Messeinheit verbunden, sodass der Beginn der Schallwelle der Messeinheit bekannt ist und entsprechend am Eingang des jeweiligen elektrischen Netzes des Prüflings anliegende Strom- oder Spannungspuls durch die Messeinheit mit dem vorgegebenen zeitlichen Versatz von beispielsweise 100 ns bis 1 $\mu$s zu dem Beginn der Schallwelle erzeugt werden kann. Am Ausgang des elektrischen Netzes des Prüflings kann dann der Stromverlauf I(t) an einem Messwiderstand gemessen werden. Vorteilhaft sind bei diesem Verfahren die zusätzlichen Möglichkeiten der Signalverarbeitung, die sich aus den zeitlich veränderlichen Größen sowohl der Spannung am Netz, als auch bei der Schallerzeugung ergeben.

Die Erfindung wird nachfolgend anhand von Ausführungsbeispielen und unter Bezugnahme auf die Figuren erläutert. Dabei bilden alle beschriebenen und/oder bildlich dargestellten Merkmale für sich oder in beliebiger Kombination den Gegenstand der Erfindung, auch unabhängig von ihrer Zusammenfassung in den Ansprüchen oder deren Rückbezügen.

Es zeigen schematisch:

Fig. 1    ein Ausführungsbeispiel einer erfindungsgemäßen Anordnung in einer Ansicht von der Seite,

Fig. 2    die Anordnung gemäß Fig. 1 in einer Schaltskizze,

Fig. 3    eine Gegenüberstellung eines am Ausgang eines elektrischen Netzes des Prüflings gemessenen zeitabhängigen Spannungssignals sowie die zugehörige Schallwelle in Abhängigkeit von der Zeit und

Fig. 4 einen Teil eines weiteren Ausführungsbeispiels einer erfindungsgemäßen Anordnung mit einem schallweichen Befestigungselement (Niederhalter) und einer Messeinheit in einem Querschnitt.

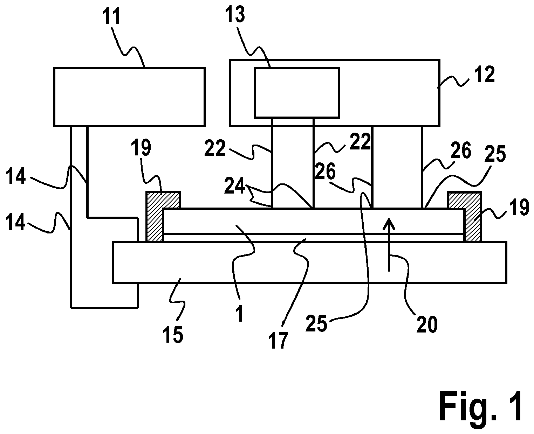

Fig. 1 zeigt eine erfindungsgemäße Anordnung für die Prüfung eines Leiterplatten-Prüflings 1 mit einer Schallerzeugungseinheit 11 und einer Messeinheit 12, die eine Gleichspannungsquelle 13 aufweist. Die Schallerzeugungseinheit 11 ist über eine elektrisch leitende Verbindung 14 mit einem Schallgeber 15, beispielsweise einer planparallelen Platte aus Quarz oder einer planparallelen Platte aus einer piezoelektrischen Keramik, verbunden. Der Prüfling 1 ist auf dem Schallgeber 15 über eine Koppelschicht 17 aus Wasser mit Detergenzien oder Gel oder Öl mittels Befestigungselementen (Niederhaltern) 19 festgelegt. Die Befestigungselemente 19 können schallhart oder schallweich ausgestaltet sein, je nachdem, ob mehrfache Reflexionen der Schallwelle in den Prüfling 1 ermöglicht oder unterbunden werden sollen. Das Befestigungselement 19 weist an den Stellen, wo sich auf dem Prüfling 1 ein Eingang 24 oder ein Ausgang 25 (Messpunkte) eines zu untersuchenden elektrischen Netzes befinden, Öffnungen auf, so dass die Nadeln eines Testadapters die Messpunkte durch das Befestigungselement 19 hindurch kontaktieren können.

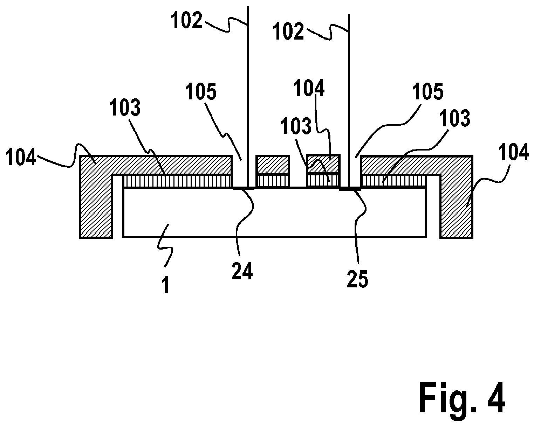

Ein Ausführungsbeispiel für ein schallweiches Befestigungselement ist in Fig. 4 dargestellt. Der Prüfling 1 ist mit einer 1 mm bis 3 mm dicken Gummimatte 103 bedeckt, welche mittels einer Metallplatte 104, die zusammen mit der Gummimatte 103 als Niederhalter dient, auf den Prüfling 101 gedrückt wird, so dass ein guter Kontakt zwischen Leiterplatte und Gummimatte 103 entsteht. Der Niederhalter aus Gummimatte 103 und Metallplatte 104 ersetzt den Niederhalter 19, der in Fig. 1 gezeigt ist. Der Niederhalter weist in den Bereichen, an denen Messsignale mit einem Nadeladapter 102 durch elektrische Verbindung mit dem Eingang 24 und dem Ausgang 25 des elektrischen Netzes vom Prüfling 1 detektiert werden sollen, jeweils eine durchgehende Öffnung 105 auf. Im Übrigen, insbesondere hinsichtlich der nicht gezeichneten Merkmale der erfindungsgemäßen Anordnung, entspricht die in Fig. 4 gezeigte Anordnung der in Fig. 1 dargestellten Anordnung.

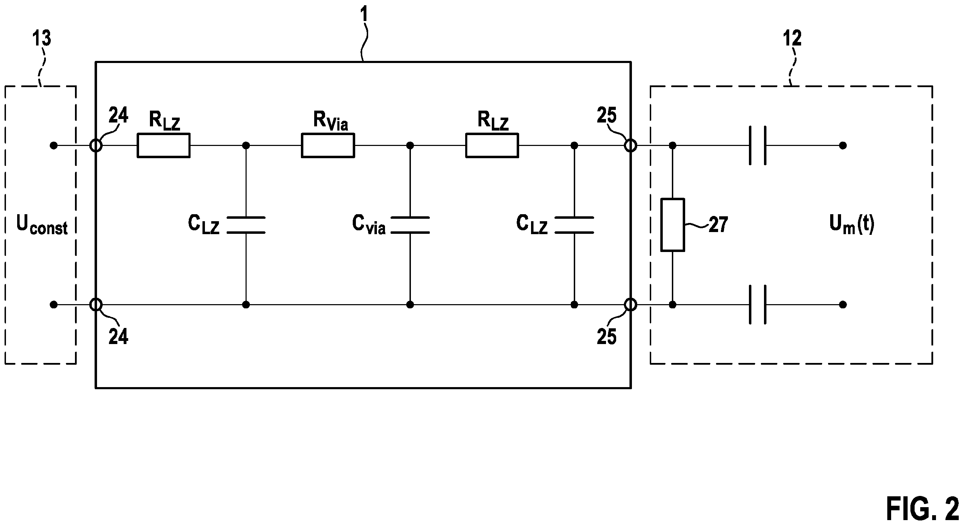

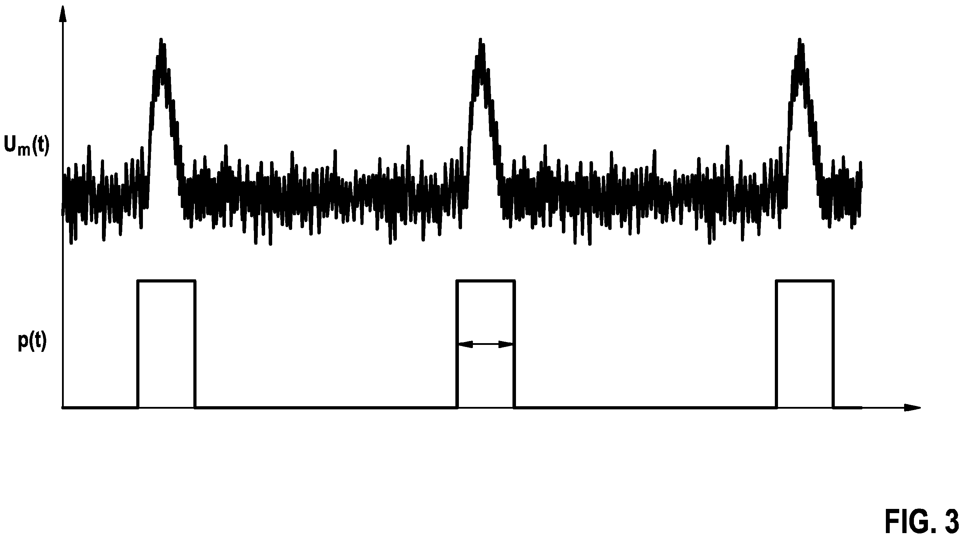

Gesteuert durch die Schallerzeugungseinheit 11 wird in dem Schallgeber 15 auf bekannte Weise eine Schallwelle $p(t)$ erzeugt, welche vorzugsweise als Stoßwelle ausgebildet ist und eine Anstiegszeit von weniger als 1 ns und einem Schalldruck mindestens 500 Pa aufweist. Die Ausbreitungsrichtung der Schallwelle verläuft senkrecht zur Fläche mit der größten Ausdehnung des Prüflings 1 (siehe Pfeil 20). Die Schallwelle $p(t)$ ist abhängig von der Zeit in Figur 3 dargestellt. Die Gleichspannungsquelle 13 mit einer Spannung $U_{const}$ ist mittels einer elektrisch leitenden Verbindung 22 mit einem Eingang 24 eines vorgegebenen, zu untersuchenden elektrischen Netzes des Prüflings 1 verbunden. Dies ist auch in Figur 2 dargestellt. Weiter ist ein Eingang der Messeinheit 12 mit dem Ausgang 25 des jeweiligen elektrischen Netzes des Prüflings 1 über eine elektrisch leitende Verbindung 26 verbunden. Die so in das elektrische Netz der Leiterplatte eingeprägte Spannung wird über das jeweilige elektrische Netz innerhalb des Prüflings 1, das in Figur 2 durch RC-Glieder schematisch dargestellt ist, verteilt. Die Spannung an dem Ausgang 25 des jeweiligen elektrischen Netzes des Prüflings wird über einen Messwiderstand 27 kapazitiv durch die Messeinheit 12 erfasst, wobei das Spannungssignal in Figur 3 als zeitabhängiges Spannungs-Messsignal $U_m(t)$ dargestellt ist. Dieses Messsignal wird der Messeinheit 12 über eine elektrisch leitende Verbindung 26 übermittelt und dort wie oben beschrieben weiter verarbeitet, beispielsweise digitalisiert, um aus dem Messsignal abzuleiten, ob der Prüfling 1 den Qualitätsanforderungen entspricht oder nicht. Bei Nichterfüllung der Qualitätsanforderungen wird der Prüfling aus dem weiteren Produktionsprozess ausgesondert.

Zur Beurteilung der Qualität des Prüflings 1 kann das Messsignal $U_m(t)$ beispielsweise mittels der Messeinheit 12 mit dem Schallsignal $p(t)$ (siehe Figur 3) gefaltet werden, wobei sich das folgende Faltungsintegral für die Bestimmung eines skalaren Messwertes G mit einer Faltungsfunktion $f(t)$ ergibt:

$$G = \int_{t=t_1}^{t=t_2} f(t) * U_m(t) * p(t) dt$$

Hierbei kann im einfachsten Fall $f(t) = 1$ angenommen werden. In diesem Fall stellt G den Mittelwert von $U_m$ während der Dauer der Stoßwelle dar.

In einem weiteren bevorzugten Ausführungsbeispiel wird als Faltungsfunktion eine Rechteckfunktion und als anregende Schallwelle eine Stoßwelle verwendet. Wenn die Stoßwelle durch eine Sprungfunktion beschrieben wird, vereinfacht sich das Faltungsintegral zu einer einfachen Integration des Messsignals über die Zeitdauer der Rechteckfunktion. Dieses Messprinzip ist in der Literatur als Boxcar Integrator bekannt und kann auf einfache Weise implementiert werden. Als Rechteckfunktion wird in zweckmäßiger Weise das Zeitfenster vom Beginn der Stoßwelle über die gesamte Laufzeit der Stoßwelle durch den Prüfling gewählt. Als Ergebnis erhält man eine skalare Größe, die zur Qualitätsbestimmung herangezogen werden kann, indem das ermittelte Integral für dasselbe elektrische Netz einer Stichprobe von gleichartig hergestellten Prüflingen verglichen wird. Bei statistisch signifikanter Abweichung des gemessenen Integrals eines elektrischen Netzes von der Stichprobe liegt ein latenter Fehler im betreffenden elektrischen Netz des Prüflings vor.

Grundsätzlich sind verschiedene Möglichkeiten vorhanden, mit der erfindungsgemäßen Anordnung die Qualität einer Leiterplatte zu beurteilen. Diese sind in der nachfolgenden Tabelle dargestellt, wobei die Spalte "Bedingung Netz (Eingang)" den durch die Messeinheit 12 vorgegebenen Zustand des Netzes in/an der Leiterplatte beschreibt. In der Spalte "Messgröße (Ausgang)" wird die am Ausgang 25 des Prüflings 1 erfasste Messgröße genannt, die mittels der Messeinheit 12 zur Qualitätsbewertung analysiert wird. Jede Zeile der Tabelle verkörpert ein separates Messverfahren. Hierbei wird jeweils die in Fig. 2 gezeigte Schaltskizze verwendet; es existieren lediglich Unterschiede in der Beschaltung des Eingangs und des Ausgangs wie in der nachfolgenden Tabelle beschrieben.

| Bedingung Netz (Eingang) | Messgröße (Ausgang) |
|---|---|
| eingeprägter konstanter Strom | Strom im Netz nach Hochpass (konstanter DC Strom abgetrennt) Spannungsverlauf U(t) am Messwiderstand |
| konstante Spannung Netz gegen Masse oder Vcc | Strom im Netz (kein DC Stromfluss) Spannungsverlauf U(t) am Messwiderstand |
| Strompuls mit variablen zeitlichem Versatz zu Stoßwelle | Stromverlauf I(t) an Messwiderstand |
| Spannungspuls gegen Masse oder Vcc mit variablen zeitlichem Versatz zu Stoßwelle | Stromverlauf I(t) an Messwiderstand |

Das erfindungsgemäße Verfahren bzw. die erfindungsgemäße Vorrichtung ermöglicht eine einfache und kostengünstige Prüfung einer Leiterplatte hinsichtlich Inhomogenitäten und Schwachstellen, die zu keiner Reduzierung der Lebensdauer der Leiterplatte führt.

**Bezugszeichenliste**

1 Leiterplatten-Prüfling
11 Schallerzeugungseinheit
12 Messeinheit
13 Gleichspannungsquelle
14 elektrisch leitende Verbindung
15 Schallgeber
17 Koppelschicht
19 Befestigungselement
20 Pfeil (Ausbreitungsrichtung der Schallwelle *p(t)*)
22 elektrisch leitende Verbindung
24 Eingang eines elektrischen Netzes des Prüflings
25 Ausgang eines elektrischen Netzes des Prüflings
26 elektrisch leitende Verbindung
27 Messwiderstand
102 Nadel des Nadeladapters der Messeinheit 12
103 Gummimatte
104 Metallplatte
105 durchgehende Öffnung

**Patentansprüche**

1. Anordnung für die Prüfung von Leiterplatten-Prüflingen (1) mit mindestens einem elektrischen Netz aufweisend

- mindestens eine Schallerzeugungseinheit (11) mit einem Schallgeber (15),
- mindestens ein Befestigungselement (19, 103, 104) zur Befestigung eines Prüflings (1) über eine Koppelschicht (17) an dem Schallgeber (15) sowie
- eine Messeinheit (12) mit einer Strom- oder Spannungsquelle (13), wobei die Strom- oder Spannungsquelle (13) elektrisch mit einem Eingang (24) eines elektrischen Netzes des Prüflings (1) verbindbar ist, wobei die Messeinheit (12) mit einem Ausgang (25) des jeweiligen elektrischen Netzes des Prüflings (1) elektrisch verbindbar und zur Erfassung eines zeitabhängigen Strom- und/oder Spannungssignals an dem Ausgang (25) des jeweiligen elektrischen Netzes des Prüflings (1) während und/oder nach Einkoppeln einer von dem Schallgeber (15) erzeugten, vorgegebenen Schallwelle über die Koppelschicht (17) in den Prüfling (1) eingerichtet ist.

2. Anordnung nach Anspruch 1, **dadurch gekennzeichnet, dass** die Messeinheit (12) die Qualität des Prüflings (1) basierend auf dem durch die Messeinheit (12) erfassten zeitabhängigen Strom- und/oder Spannungssignal beurteilt.

3. Anordnung nach einem der vorhergehenden Ansprüche, **dadurch gekennzeichnet, dass** die Messeinheit (12) zur kapazitiven Erfassung eines zeitabhängigen Spannungssignals am Ausgang des jeweiligen elektrischen Netzes des Prüflings (1) eingerichtet ist.

4. Anordnung nach einem der vorhergehenden Ansprüche, **dadurch gekennzeichnet, dass** die Schallwelle durch den Schallgeber (15) senkrecht zu der größten Flächenausdehnung des Prüflings (1) aussendbar und über die Koppelschicht (17) in den Prüfling (1) einkoppelbar ist.

5. Anordnung nach einem der vorhergehenden Ansprüche, **dadurch gekennzeichnet, dass** das mindestens eine Befestigungselement (19, 103, 104) als schallweicher oder schallharter Niederhalter ausgebildet ist.

6. Anordnung nach einem der vorhergehenden Ansprüche, **dadurch gekennzeichnet, dass** die Messeinheit (12) zum Vergleich und/oder Faltung des erfassten Strom- und/oder Spannungssignals mit der vorgegebenen Schallwelle eingerichtet ist.

7. Anordnung nach einem der vorhergehenden Ansprüche, **dadurch gekennzeichnet, dass** die Strom- oder Spannungsquelle (13) als Gleichstrom- bzw. Gleichspannungsquelle ausgebildet ist.

8. Anordnung nach einem der Ansprüche 1 bis 6, **dadurch gekennzeichnet, dass** die Strom- oder Spannungsquelle (13) zur Erzeugung eines Strom- oder Spannungspulses am Eingang (24) des jeweiligen elektrischen Netzes des Prüflings (1) in einem vorgegebenen zeitlichen Abstand zu dem Beginn der vorgegebenen Schallwelle eingerichtet ist.

9. Verfahren zur Prüfung von Leiterplatten-Prüflingen (1) mit mindestens einem elektrischen Netz mit den folgenden Schritten

- Befestigung eines Prüflings (1) über eine Koppelschicht (17) an einem Schallgeber (15) einer Schallerzeugungseinheit (11), wobei die Koppelschicht (17) zwischen Prüfling (1) und Schallgeber (15) angeordnet ist,
- elektrisches Verbinden einer Strom- oder Spannungsquelle (13) einer Messeinheit (12) mit einem Eingang (24) eines elektrischen Netzes des Prüflings (1),
- Erfassen eines zeitabhängigen Strom- und/oder Spannungssignals an einem Ausgang (25) des jeweiligen elektrischen Netzes des Prüflings (1) während und/oder nach dem Einkoppeln einer von dem Schallgeber (15) erzeugten, vorgegebenen Schallwelle über die Koppelschicht (17) in den Prüfling (1).

10. Verfahren nach Anspruch 9, **dadurch gekennzeichnet, dass** die Qualität des Prüflings (1) basierend auf dem durch die Messeinheit (12) erfassten zeitabhängigen Strom- und/oder Spannungssignal beurteilt wird.

11. Verfahren nach einem der Ansprüche 9 und 10, **dadurch gekennzeichnet, dass** ein zeitabhängiges Spannungssignal kapazitiv durch die Messeinheit (12) am Ausgang des jeweiligen elektrischen Netzes des Prüflings (1) erfasst wird.

12. Verfahren nach einem der Ansprüche 9 bis 11, **dadurch gekennzeichnet, dass** die Schallwelle durch den Schallgeber (15) senkrecht zu der größten Flächenausdehnung des Prüflings (1) ausgesendet und über die Koppelschicht (17) in den Prüfling (1) einkoppelt wird.

**13.** Verfahren nach einem der Ansprüche 9 bis 12, **dadurch gekennzeichnet, dass** durch die Messeinheit (12) das erfasste Strom- und/oder Spannungssignal mit der vorgegebenen Schallwelle verglichen oder gefaltet wird.

**14.** Verfahren nach einem der Ansprüche 9 bis 13, **dadurch gekennzeichnet, dass** die Strom- oder Spannungsquelle (13) einen Gleichstrom bzw. eine Gleichspannung erzeugt.

**15.** Verfahren nach einem der Ansprüche 9 bis 13, **dadurch gekennzeichnet, dass** die Strom- oder Spannungsquelle (13) einen Strom- oder Spannungspulses am Eingang des jeweiligen elektrischen Netzes des Prüflings (1) in einem vorgegebenen zeitlichen Abstand zu dem Beginn der vorgegebenen Schallwelle erzeugt.

Fig. 1

FIG. 2

EP 3 312 624 A1

U_m(t)

p(t)

EP 3 312 624 A1

**FIG. 3**

**Fig. 4**

Europäisches
Patentamt

European
Patent Office

Office européen
des brevets

# EUROPÄISCHER RECHERCHENBERICHT

Nummer der Anmeldung

EP 16 19 4366

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | CA 2 576 590 A1 (QUEBEC CENTRE RECH IND [CA]) 30. Juli 2008 (2008-07-30) | 1-5, 7-10,12, 15 | INV. G01R31/28 |
| A | * Abbildungen 1a-b, 2, 3 * <br> * Ansprüche 6,17-21 * <br> * Seite 1, Zeile 5 - Zeile 8 * <br> * Seite 7, Zeile 34 - Seite 11, Zeile 11 * <br> * Seite 13, Zeile 27 - Seite 19, Zeile 19 * | 6,13 | ADD. G01M7/00 G01N29/28 G01R31/304 H04R17/00 G01R31/312 |
| L | & US 6 668 650 B1 (LAFLEUR FRANCOIS [CA] ET AL) 30. Dezember 2003 (2003-12-30) <br> * Ansprüche 1-3 * <br> * Abbildungen 2,3,4a-b,5,9 * <br> * Spalte 5, Zeile 66 - Spalte 8, Zeile 13 * <br><br> * Spalte 1, Zeile 6 - Zeile 9 * <br> * Spalte 3, Zeile 40 - Zeile 52 * <br> * Spalte 9, Zeile 23 - Spalte 10, Zeile 65 * <br><br> * Spalte 13, Zeile 11 - Zeile 38 * <br> ----- | | |
| A | US 5 471 877 A (BROWN EDWIN Z [US]) 5. Dezember 1995 (1995-12-05) <br> * das ganze Dokument * <br> ----- | 1,9 | |
| A | DE 197 47 399 A1 (SIEMENS AG [DE]) 6. Mai 1999 (1999-05-06) <br> * das ganze Dokument * <br> ----- | 1,9 | |
| A | DE 10 2013 111319 A1 (GE SENSING & INSPECTION TECH [DE]) 16. April 2015 (2015-04-16) <br> * das ganze Dokument * <br> ----- | 1,9 | |
| A | US 5 836 192 A (GETMAN IGOR [DE] ET AL) 17. November 1998 (1998-11-17) <br> * das ganze Dokument * <br> ----- <br> -/-- | 1,9 | |

RECHERCHIERTE SACHGEBIETE (IPC)

G01R
G01M
G01N
H04R
H01L
B06B
G10K

Der vorliegende Recherchenbericht wurde für alle Patentansprüche erstellt

| Recherchenort | Abschlußdatum der Recherche | Prüfer |
|---|---|---|
| München | 7. April 2017 | Nguyen, Minh |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

....................................................................
& : Mitglied der gleichen Patentfamilie, übereinstimmendes Dokument

EPO FORM 1503 03.82 (P04C03)

Seite 1 von 2

Europäisches Patentamt

European Patent Office

Office européen des brevets

**EUROPÄISCHER RECHERCHENBERICHT**

Nummer der Anmeldung

EP 16 19 4366

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | Mel Schwartz: "Couplants" In: "Smart Materials", 20. November 2008 (2008-11-20), CRC Press, XP055362017, ISBN: 978-1-4200-4372-3 Seiten 32-3, * das ganze Dokument * ----- | 1,9 | |
| A | US 2011/204910 A1 (SUTO ANTHONY J [US]) 25. August 2011 (2011-08-25) * das ganze Dokument * ----- | 3,11 | |
| A | US 6 825 673 B1 (YAMAOKA SHUJI [JP]) 30. November 2004 (2004-11-30) * das ganze Dokument * ----- | 3,11 | |
| A | Unknown: "Widerstandsmessung", Keysight 34970A/34972A Messdatenerfassungs-/ Schaltsystem, 1. November 2014 (2014-11-01), Seiten 295-296, XP055362148, Gefunden im Internet: URL:http://www.keysight.com/de/pd-100000131 3%3Aepsg%3Apro-pn-34970A/data-acquisition -data-logger-switch-unit?pm=PL&nid=-33261. 536881544&cc=DE&lc=ger [gefunden am 2017-04-05] * das ganze Dokument * ----- | 1,7,9,14 | RECHERCHIERTE SACHGEBIETE (IPC) |

Der vorliegende Recherchenbericht wurde für alle Patentansprüche erstellt

| Recherchenort | Abschlußdatum der Recherche | Prüfer |
|---|---|---|
| München | 7. April 2017 | Nguyen, Minh |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 16 19 4366

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

07-04-2017

| Im Recherchenbericht angeführtes Patentdokument | Datum der Veröffentlichung | Mitglied(er) der Patentfamilie | Datum der Veröffentlichung |
|---|---|---|---|
| CA 2576590 A1 | 30-07-2008 | KEINE | |
| US 5471877 A | 05-12-1995 | KEINE | |
| DE 19747399 A1 | 06-05-1999 | KEINE | |
| DE 102013111319 A1 | 16-04-2015 | DE 102013111319 A1<br>WO 2015055488 A1 | 16-04-2015<br>23-04-2015 |
| US 5836192 A | 17-11-1998 | CA 2187839 A1<br>DE 19538678 A1<br>EP 0769682 A2<br>JP 2911834 B2<br>JP H09113334 A<br>US 5836192 A<br>ZA 9608357 B | 18-04-1997<br>24-04-1997<br>23-04-1997<br>23-06-1999<br>02-05-1997<br>17-11-1998<br>27-05-1997 |
| US 2011204910 A1 | 25-08-2011 | CN 102209902 A<br>EP 2344897 A2<br>US 2011204910 A1<br>WO 2010056346 A2 | 05-10-2011<br>20-07-2011<br>25-08-2011<br>20-05-2010 |
| US 6825673 B1 | 30-11-2004 | CN 1361868 A<br>US 6825673 B1 | 31-07-2002<br>30-11-2004 |

EPO FORM P0461

Für nähere Einzelheiten zu diesem Anhang : siehe Amtsblatt des Europäischen Patentamts, Nr.12/82